(19)

**Europäisches Patentamt**
**European Patent Office**
**Office européen des brevets**

(11) **EP 4 644 929 A1**

(12) **EUROPEAN PATENT APPLICATION**
published in accordance with Art. 153(4) EPC

(43) Date of publication:
**05.11.2025 Bulletin 2025/45**

(21) Application number: **24767410.4**

(22) Date of filing: **06.03.2024**

(51) International Patent Classification (IPC):
$G01R\ 31/385^{(2019.01)}$    $G01R\ 31/396^{(2019.01)}$
$G01R\ 31/367^{(2019.01)}$    $G01R\ 19/00^{(2006.01)}$
$G01R\ 19/165^{(2006.01)}$

(52) Cooperative Patent Classification (CPC):
**G01R 19/00; G01 19/165; G01R 31/367;**
**G01R 31/385; G01R 31/396;** Y02E 60/10

(86) International application number:
**PCT/KR2024/002871**

(87) International publication number:
**WO 2024/186122 (12.09.2024 Gazette 2024/37)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **09.03.2023 KR 20230031451**

(71) Applicant: **LG Energy Solution, Ltd.**
**Seoul 07335 (KR)**

(72) Inventors:
- **HAN, Sa Rang**
  **Daejeon 34122 (KR)**
- **KIM, Sung Tae**
  **Daejeon 34122 (KR)**
- **KANG, Joon Sup**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **LOW-VOLTAGE BATTERY CELL SELECTING APPARATUS AND OPERATING METHOD THEREOF**

(57) A low-voltage battery cell sorting apparatus according to an embodiment disclosed herein includes a data obtaining unit configured to obtain processing data sets of battery cells included in each of a plurality of battery trays, a data pre-processing unit configured to generate derived variable data sets comprising at least two types of derived variables for each of the battery cells, by using the processing data sets, and standardize the derived variable data sets, and a sorting unit configured to sort, as a low-voltage battery cell, a battery cell having a standardized derived variable data set out of a designated range among the standardized derived variable data sets, by using an artificial intelligence model.

FIG.2

EP 4 644 929 A1

**Description**

**[TECHNICAL FIELD]**

CROSS-REFERENCE TO RELATED APPLICATION

This application claims priority to and the benefit of Korean Patent Application No. 10-2023-0031451 filed in the Korean Intellectual Property Office on March 9, 2023, the entire content of which is incorporated herein by reference.

TECHNICAL FIELD

Embodiments disclosed herein relate to a low-voltage battery cell sorting apparatus and an operating method thereof.

**[BACKGROUND ART]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

In a process of producing a battery cell, a defective battery cell may be produced. Herein, a defect may include a defect due to a low voltage, a defect due to an internal short-circuit, etc.

When the defective battery cell is mounted ton an electronic product, a fire may occur due to explosion of a battery, leading to loss of lives and property damage. As a result, among produced battery cells, a defective battery cell needs to be sorted.

**[DISCLOSURE]**

**[TECHNICAL PROBLEM]**

In a conventional battery manufacturing process, a designated number of battery cells are included in one tray to detect a low-voltage battery cell for each tray. For example, an OCV of battery cells for each tray may be measured and an average and a standard deviation of dOCV2(OCV1 - OCV2) of battery cells may be used to sort a low-voltage battery cell.

However, only a deviation inside a tray is considered without considering a deviation between trays, such that there is no determination criterion applicable to all trays and thus inspection needs to be performed on each tray, consuming a lot of inspection time.

Moreover, a rate of low-voltage battery cells among all produced battery cells is about 1% or less, such that when a low-voltage battery cell is sorted for each tray, efficiency with respect to an inspection time required for sorting is degraded.

Technical problems of the embodiments disclosed herein are not limited to the above-described technical problems, and other unmentioned technical problems would be clearly understood by one of ordinary skill in the art from the following description.

**[TECHNICAL SOLUTION]**

A low-voltage battery cell sorting apparatus according to an embodiment disclosed herein includes a data obtaining unit configured to obtain processing data sets of battery cells included in each of a plurality of battery trays, a data pre-processing unit configured to generate derived variable data sets including at least two types of derived variables for each of the battery cells, by using the processing data sets, and standardize the derived variable data sets, and a sorting unit configured to sort, as a low-voltage battery cell, a battery cell having a standardized derived variable data set out of a designated range among the standardized derived variable data sets, by using an artificial intelligence model.

In an embodiment, the data pre-processing unit may be further configured to standardize the derived variable data sets by using an average and a standard deviation based on a quartile of the derived variable data sets.

In an embodiment, the artificial intelligence model may be trained by training data sets for a normal battery cell, and may learn a distribution pattern of the training data sets by using a distribution chart based on at least two types of

EP 4 644 929 A1

derived variables among a plurality of derived variables.

In an embodiment, the designated range may be a boundary determined based on the distribution pattern, and the sorting unit may be further configured to sort, as the low-voltage battery cell, a battery cell having a standardized derived variable data set out of the determined boundary.

In an embodiment, the processing data sets may include an open circuit voltage (OCV) measured according to a time sequence of an activation process for each of the battery cells.

An operating method of a low-voltage battery cell sorting apparatus according to an embodiment disclosed herein includes obtaining processing data sets of battery cells included in each of a plurality of battery trays, generating derived variable data sets including at least two types of derived variables for each of the battery cells, by using the processing data sets, standardizing the derived variable data sets, and sorting, as a low-voltage battery cell, a battery cell having a standardized derived variable data set out of a designated range among the standardized derived variable data sets, by using an artificial intelligence model.

In an embodiment, the standardizing may include standardizing the derived variable data sets by using an average and a standard deviation based on a quartile of the derived variable data sets.

In an embodiment, the artificial intelligence model may be trained by training data sets for a normal battery cell, and may learn a distribution pattern of the training data sets by using a distribution chart based on at least two types of derived variables among a plurality of derived variables.

In an embodiment, the designated range may be a boundary determined based on the distribution pattern, and the sorting may include sorting, as the low-voltage battery cell, a battery cell having a standardized derived variable data set out of the determined boundary.

In an embodiment, the processing data sets may include an open circuit voltage (OCV) measured according to a time sequence of an activation process for each of the battery cells.

**[ADVANTAGEOUS EFFECTS]**

The low-voltage battery cell sorting apparatus and the operating method thereof according to various embodiments disclosed herein may convert processing data sets based on a plurality of derived variables, thereby considering a deviation inside a tray. Moreover, by standardizing a derived variable data set, a deviation between trays may be considered. That is, the present disclosure may integrally manage battery cells included in all trays by considering both the deviation inside a tray and the deviation between trays, thereby reducing an inspection to sort a low-voltage battery cell.

Thus, by shortening an inspection time to sort a low-voltage battery cell in a battery cell manufacturing process, a rapidly increasing demand for batteries may be quickly responded. In addition, a cost reduction effect may occur due to reduction of the inspection time.

The effects of the low-voltage battery cell sorting apparatus and the operating method thereof according to the disclosure of the present document are not limited to the effects mentioned above, and other effects not mentioned will be clearly understood by those of ordinary skill in the art according to the disclosure of the present document.

**[DESCRIPTION OF DRAWINGS]**

FIG. 1 shows a problem of a method of sorting a low-voltage battery cell according to a conventional art.
FIG. 2 is a block diagram of a low-voltage battery cell sorting apparatus according to an embodiment of the present disclosure.
FIG. 3 shows a first distribution chart of standardized data based on a first derived variable and a second derived variable, according to an embodiment of the present disclosure.
FIG. 4 shows a second distribution chart of standardized data based on a third derived variable and a second derived variable, according to an embodiment of the present disclosure.
FIG. 5 is a flowchart showing an operating method of a low-voltage battery cell sorting apparatus according to an embodiment of the present disclosure.

With regard to the description of the drawings, similar reference numerals may be used to refer to similar or related components.

**[MODE FOR INVENTION]**

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

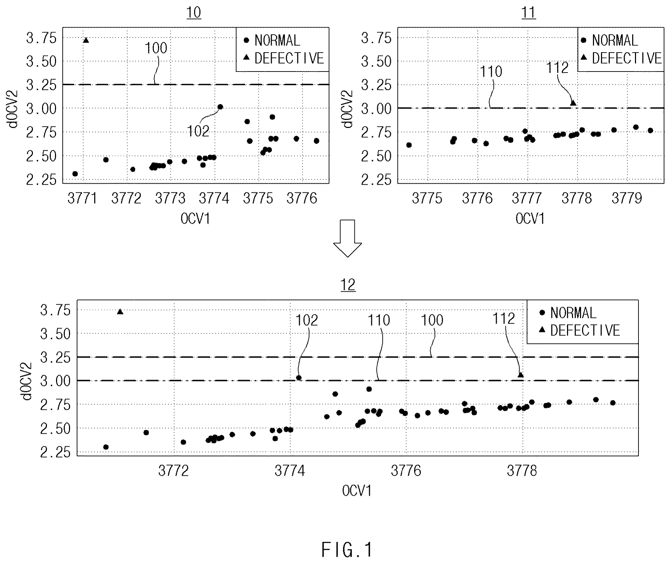

FIG. 1 shows a problem of a method of sorting a defective battery cell according to a conventional art.

Referring to FIG. 1, a first graph 10 shows dOCV2 of each battery cell included in a first tray. Herein, dOCV2(OCV1 - OCV2) may be a difference between OCV1 and OCV2 for each battery cell. Herein, OCV1 may be an open circuit voltage (OCV) temporally measured earlier than OCV2. The OCV may be measured in an activation process. The activation process may be a process of identifying safety for the battery after an assembly process for the battery. By repeating charge or discharge of the battery through the activation process, the safety of the battery may be tested based on data measured for the battery.

A cutoff 100 for the first tray may be set based on an average and a standard deviation of dOCV2 for battery cells included in the first tray. Battery cells less than the cutoff 100 for the first tray may be classified as normal battery cells, and battery cells greater than or equal to the cutoff 100 for the first tray may be classified as defective battery cells. Herein, a tray is a bundle unit of a certain number of produced battery cells classified, and may be a box including a plurality of battery cells. For example, when 3000 battery cells are generated, 30 battery cells may be included in each of 100 trays. The cutoff may be one of reference values for sorting a low-voltage battery cell. The cutoff may be a value set based on an average and a standard deviation $\sigma$ of battery cells except for a suspected low-voltage group for each tray. For example, the cutoff may be a value based on a sum of an average of dOCV2 and $4\sigma$.

Hereinbelow, a defective battery cell may be referred to as a low-voltage battery cell. However, this is merely a premise for describing the present disclosure, and a defective battery cell is not limited to a low-voltage battery cell and may also be referred to as a battery cell corresponding to various defect types.

A second graph 11 shows dOCV2 of each battery cell included in a second tray. A cutoff 110 for the second tray may be set based on an average and a standard deviation of dOCV2 for battery cells included in the second tray. Battery cells less than the cutoff 110 for the second tray may be classified as normal battery cells, and battery cells greater than or equal to the cutoff 110 for the second tray may be classified as low-voltage battery cells.

Referring to a third graph 13 integrally showing the first graph 10 and the second graph 11, data 102 regarding a battery cell classified as a normal battery cell on the first graph 10 may be greater than or equal to the cutoff 110 for the second tray, and thus the battery cell may be classified as a low-voltage battery cell. Likewise, on the second graph 11, data 112 regarding a battery cell classified as a low-voltage battery cell is less than the cutoff 100 for the first tray, and thus the battery cell may be classified as a normal battery.

That is, as an average and a standard deviation of dOCV2 for battery cells are different and thus a cutoff for determining a low voltage may also differ for each tray, it is necessary to derive an integral reference value applicable regardless of a tray.

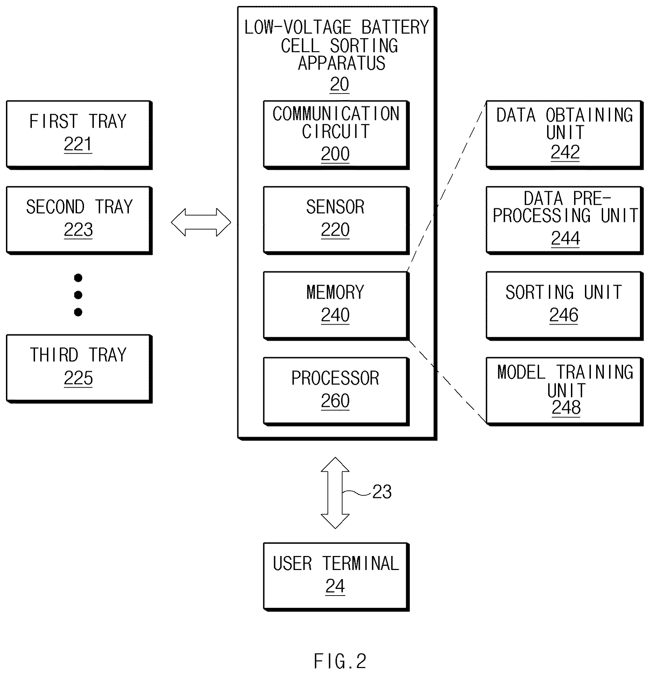

FIG. 2 is a block diagram of a low-voltage battery cell sorting apparatus 20 according to an embodiment of the present disclosure.

Referring to FIG. 2, the low-voltage battery cell sorting apparatus 20 may be wiredly and/or wirelessly connected to a user terminal 24.

In an embodiment, connection 23 between the low-voltage battery cell sorting apparatus 20 and the user terminal 24 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

In another embodiment, the connection 23 between the low-voltage battery cell sorting apparatus 20 and the user terminal 24 may be connection using a device-to-device communication scheme (e.g., a bus, a general-purpose input and output (GPIO), a serial peripheral interface (SPI), or a mobile industry processor interface (MIPI)).

In an embodiment, each of a plurality of trays 221, 223, and 225 may include a plurality of battery cells manufactured.

In an embodiment, the user terminal 24 may be a mobile device (e.g., a mobile phone, a laptop computer, a smart phone, a smart pad), or a personal computer (PC), which controls the low-voltage battery cell sorting apparatus 20.

In an embodiment, the low-voltage battery cell sorting apparatus 20 may include a communication circuit 200, a sensor 220, a memory 240, and a processor 260. According to an embodiment, the low-voltage battery cell sorting apparatus 20 shown in FIG. 2 may further include at least one component (e.g., a display, an input device, or an output device) in addition to components shown in FIG. 2.

In an embodiment, the communication circuit 200 may establish a wired communication channel and/or a wireless communication channel between the low-voltage battery cell sorting apparatus 20 and the user terminal 24, and transmit and receive data to and from the user terminal 24 through the established communication channel.

In an embodiment, the sensor 220 may obtain processing data sets for battery cells included in the plurality of trays 221, 223, and 225. In an embodiment, the processing data sets may include data regarding an OCV of a battery cell. Herein, the processing data set may include an OCV measured according to a time sequence of the activation process for each of the battery cells. For example, the processing data set may include a primarily measured OCV OCV1, a secondarily measured OCV OCV2, and a tertiarily measured OCV OCV3 for a battery cell, and each order may be identified according to the time sequence of the activation process.

In an embodiment, the memory 240 may include a volatile and/or a nonvolatile memory.

In an embodiment, the memory 240 may store data used by at least one component (e.g., the processor 260) of the low-voltage battery cell sorting apparatus 20. For example, the data may include software (or an instruction related thereto), input data, or output data. In an embodiment, the instruction, when executed by the processor 260, may cause the low-voltage battery cell sorting apparatus 20 to perform operations defined by the instruction.

In an embodiment, the memory 240 may include one or more software (e.g., a data obtaining unit 242, a data pre-processing unit 244, a sorting unit 246, and a model training unit 248).

In an embodiment, the processor 260 may include a central processing unit, an application processor, a graphic processing unit, a neural processing unit (NPU), an image signal processor, a sensor hub processor, or a communication processor.

In an embodiment, the processor 260 may execute software (e.g., the data obtaining unit 242, the data pre-processing unit 244, the sorting unit 246, and the model training unit 248) to control at least one other component (e.g., a hardware or software component) of the low-voltage battery cell sorting apparatus 20 connected to the processor 260 and perform various data processing or operations.

Hereinbelow, referring to FIGS. 2 to 5, a description will be made of a method, performed by the low-voltage battery cell sorting apparatus 20, of sorting a low-voltage battery cell among produced battery cells through the data obtaining unit 242, the data pre-processing unit 244, the sorting unit 246, and the model training unit 248.

The data obtaining unit 242 may obtain processing data sets for a plurality of battery trays. The data obtaining unit 242 may obtain processing data sets for battery cells included in the plurality of battery trays through the sensor 220.

The data pre-processing unit 244 may pre-process raw data. The data pre-processing unit 244 may pre-process a processing data set.

The data pre-processing unit 244 may pre-process a processing data set by generating a derived variable data set from the processing data set. The data pre-processing unit 244 may pre-process derived variable data for each of a plurality of derived variables from the processing data set by using an OCV of the processing data set. Herein, the derived variable data set may include the derived variable data for each of the plurality of derived variables. For example, the data pre-processing unit 244 may generate the derived variable data set including the derived variable data in which the processing data set is converted into each of three derived variables by using the OCV of the battery cell. The data pre-processing unit 244 may further pre-process a processing data set by standardizing the derived variable data set based on the processing data set. The data pre-processing unit 244 may generate the standardized derived variable data set by performing standardization on each of the derived variable data included in the derived variable data set.

In an embodiment, the data pre-processing unit 244 may convert OCV values included in the processing data set of the battery cell into a form for each of the plurality of derived variables. The data pre-processing unit 244 may generate derived variable data in which OCV values included in the processing data set of the battery cell are converted into a form for each of the plurality of derived variables. Herein, the derived variable may be a variable based on an OCV value of a battery cell. For example, the number of derived variables may be 3, and three derived variables may be expressed based on Equation 1 to Equation 3.

$$[\text{Equation 1}]$$

$$\text{First Derived Variable} = \frac{dOCV2 - \mu}{\sigma}$$

Herein, dOCV2 may be a difference between OCV1 and OCV2 measured for a battery cell, $\mu$ may be an average of dOCV2 of battery cells for each tray, and $\sigma$ may be a standard deviation of dOCV2 of battery cells for each tray.

$$[\text{Equation 2}]$$

$$\text{Second Derived Variable} = dOCV2 - cutoff$$

Herein, the cutoff may be one of reference values for sorting a conventionally used low-voltage battery cell. The cutoff may be a value set based on an average and a standard deviation of battery cells except for a suspected low-voltage group for each tray. For example, the cutoff may correspond to a sum of an average of dOCV2 and $4\sigma$.

$$[\text{Equation 3}]$$

$$\text{Third Derived Variable} = \frac{dOCV2}{OCV1}$$

In an embodiment, the data pre-processing unit 244 may standardize derived variable data sets by using an average and a standard deviation based on a quartile of derived variable data sets. The data pre-processing unit 244 may calculate an average and a standard deviation of derived variable data sets present in a first quartile Q1 to a third quartile Q3 based on an IQR for a derived variable data set, and standardize the derived variable data set by using the calculated average and standard deviation. Herein, the IQR, which is an interquartile range, may indicate a degree of distribution of data except for data of upper 25 % and lower 25 % when the derived variable data sets for all the battery cells are listed in an ascending order for each of the plurality of derived variables. The derived variable data set may be standardized based on Equation 4.

[Equation 4]

$$\frac{X_i - \overline{X_{[Q1,Q3]}}}{S_{[Q1,Q3]}}$$

Herein, X may be at least one derived variable data included in a derived variable data set. Q1 may be derived variable data corresponding to the first quartile, and Q3 may be derived variable data corresponding to the third quartile. $\overline{X_{[Q1,Q3]}}$ and $S_{[Q1,Q3]}$ may be an average and a standard deviation of derived variable data present in the first quartile and the third quartile.

Among all data sets, a data set distributed at opposite ends may be a data set corresponding to a defective battery cell for other reasons than a low voltage, such that the data pre-processing unit 244 may perform standardization. As the data pre-processing unit 244 performs standardization except for data sets distributed at opposite ends among all the data sets, the present disclosure may ultimately improve the accuracy of sorting a low-voltage battery cell.

The data pre-processing unit 244 may reflect a deviation inside a tray by converting values of the processing data set into a derived variable data set based on a derived variable, and reflect a deviation between trays by standardizing on the derived variable data set. Thus, the present disclosure may manage data having a different distribution chart for each tray by integrating the same into standardized data.

Hereinbelow, a method of training an artificial intelligence model for sorting a low-voltage battery cell based on pre-processed data and a method of sorting a low-voltage battery cell by using a pre-trained artificial intelligence model will be described.

Method of Training Artificial Intelligence Model

The model training unit 248 may train an artificial intelligence model by using training data sets. Herein, the training data set may be a processing data set for a normal battery cell. The training data set may be a derived variable data set for a normal battery cell. The training data set may be a standardized derived variable data set for a normal battery cell.

The model training unit 248 may learn a distribution pattern for a normal battery cell by using the training data sets. For example, the model training unit 248 may learn a distribution pattern for normal battery cells based on a distribution of the training data sets with respect to a first derived variable and a second derived variable.

Method of Sorting Low-Voltage Battery Cell

The sorting unit 246 may sort a low-voltage battery cell by using a pre-trained artificial intelligence model. The sorting unit 246 may sort a low-voltage battery cell by using an artificial intelligence model trained by the model training unit 248.

In an embodiment, the sorting unit 246 may sort a battery cell having a standardized processing data set out of a designated range from the learned distribution pattern.

In an embodiment, the sorting unit 246 may determine a boundary between a normal battery cell and a low-voltage battery cell. The sorting unit 246 may determine the boundary between the normal battery cell and the low-voltage battery cell based on the learned distribution pattern. The sorting unit 246 may sort a battery cell having a standardized processing data set not falling within the determined boundary, as a low-voltage battery cell. Herein, the determined boundary may be a boundary value of a region based on the distribution pattern for the normal battery cell. A region within the boundary, determined based on the determined boundary, may be a region determined as a normal battery cell, and a region out of the determined boundary may be a region determined as a low-voltage battery cell.

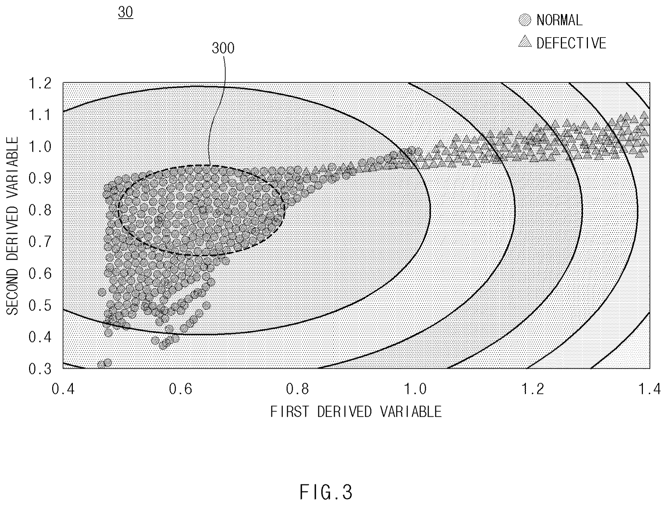

FIG. 3 shows a first distribution chart 30 of standardized data based on a first derived variable and a second derived variable, according to an embodiment of the present disclosure.

Referring to FIG. 3, on the first distribution chart 30 for the standardized data based on the first derived variable and the second derived variable, a distribution of standardized derived variable data sets for a plurality of battery cells may be shown.

The model training unit 248 may learn a distribution pattern for a normal battery cell based on the distribution of standardized derived variable data. In an embodiment, the model training unit 248 may cause an artificial intelligence model to learn a distribution pattern for a normal battery cell based on a data density on the first distribution chart 30. In another embodiment, the model training unit 248 may cause an artificial intelligence model to learn a distribution pattern for a normal battery cell based on an average and a standard deviation of standardized derived variable data sets.

The sorting unit 246 may sort a battery cell corresponding to data out of a designated range from the distribution pattern derived by the model training unit 248 as a defective battery cell due to a low voltage.

On the first distribution chart, a determined boundary 300 may be further indicated. Herein, the determined boundary may mean a reference boundary value for determining whether a corresponding battery cell is a normal battery cell based on the learned distribution pattern.

The sorting unit 246 may sort a battery cell corresponding to the standardized derived variable data set not falling within the determined boundary 300, as a defective battery cell due to a low voltage. For example, the sorting unit 246 may sort a battery cell having a standardized derived variable data set distributed within the determined boundary 300, as a normal battery cell, based on the determined boundary 300.

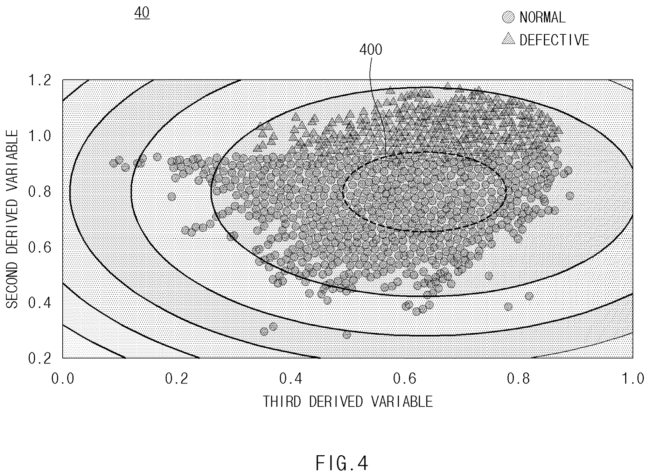

FIG. 4 shows a second distribution chart 40 of standardized data based on a third derived variable and a second derived variable, according to an embodiment of the present disclosure.

Referring to FIG. 4, on the second distribution chart 40 for the standardized data based on the third derived variable and the second derived variable, a distribution of standardized derived variable data sets for each of a plurality of battery cells may be shown.

Like in FIG. 3, the model training unit 248 may learn a distribution pattern for a normal battery cell based on the distribution of standardized derived variable data sets.

The sorting unit 246 may sort a battery cell having a standardized derived variable data set out of a designated range from the distribution pattern derived by the model training unit 248 as a defective battery cell due to a low voltage.

On the second distribution chart 40, a determined boundary 400 may be further indicated. The sorting unit 246 may sort a battery cell having the standardized derived variable data set not falling within the determined boundary 400, as a defective battery cell due to a low voltage. For example, the sorting unit 246 may classify a battery cell having a standardized derived variable data set distributed within the determined boundary 400, as a normal battery cell, based on the determined boundary 400.

The first distribution chart and the second distribution chart described with reference to FIGS. 3 and 4 above regard to plane distribution charts based on two derived variables, but this is merely an example and the present disclosure is not limited thereto. The present disclosure may sort a low-voltage battery cell by using a spatial distribution chart based on three derived variables.

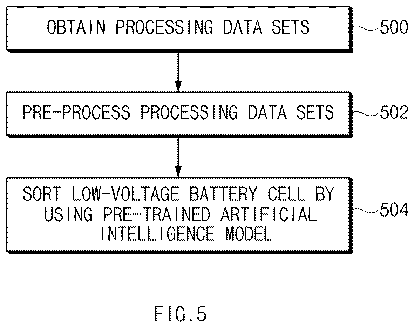

FIG. 5 is a flowchart showing an operating method of the low-battery cell sorting apparatus 20 according to an embodiment of the present disclosure.

Referring to FIG. 5, in operation 500, the data obtaining unit 242 may obtain processing data sets for a plurality of battery trays. The data obtaining unit 242 may obtain processing data sets for battery cells included in the plurality of battery trays through the sensor 220.

In operation 502, The data pre-processing unit 244 may pre-process raw data. The data pre-processing unit 244 may pre-process a processing data set.

The data pre-processing unit 244 may pre-process a processing data set by converting the processing data set into a derived variable data set. The data pre-processing unit 244 may convert the processing data set into derived variable data for each of a plurality of derived variables, by using an OCV of the processing data set.

In an embodiment, the data pre-processing unit 244 may convert OCV values included in the processing data set of the battery cell into a form for each of the plurality of derived variables. The data pre-processing unit 244 may generate derived variable data in which OCV values included in the processing data set of the battery cell are converted into a form for each of the plurality of derived variables.

In an embodiment, the data pre-processing unit 244 may standardize derived variable data sets by using an average and a standard deviation based on a quartile of derived variable data sets. The data pre-processing unit 244 may calculate an average and a standard deviation of derived variable data sets present in a first quartile Q1 to a third quartile Q3 based on an IQR for a derived variable data set, and standardize the derived variable data set by using the calculated average and standard deviation.

In operation 504, the sorting unit 246 may sort a low-voltage battery cell by using a pre-trained artificial intelligence model. The sorting unit 246 may sort a low-voltage battery cell by using an artificial intelligence model trained by the model training unit 248.

In an embodiment, the sorting unit 246 may sort a battery cell having a standardized processing data set out of a designated range from the learned distribution pattern.

In an embodiment, the sorting unit 246 may determine a boundary between a normal battery cell and a low-voltage battery cell. The sorting unit 246 may determine the boundary between the normal battery cell and the low-voltage battery cell based on the learned distribution pattern. The sorting unit 246 may sort a battery cell having a standardized processing data set not falling within the determined boundary, as a low-voltage battery cell.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

**Claims**

1. A low-voltage battery cell sorting apparatus comprising:

   a data obtaining unit configured to obtain processing data sets of battery cells included in each of a plurality of battery trays;
   a data pre-processing unit configured to generate derived variable data sets comprising at least two types of derived variables for each of the battery cells, by using the processing data sets, and standardize the derived variable data sets; and
   a sorting unit configured to sort, as a low-voltage battery cell, a battery cell having a standardized derived variable data set out of a designated range among the standardized derived variable data sets, by using an artificial intelligence model.

2. The low-voltage battery cell sorting apparatus of claim 1, wherein the data pre-processing unit is further configured to standardize the derived variable data sets by using an average and a standard deviation based on a quartile of the derived variable data sets.

3. The low-voltage battery cell sorting apparatus of claim 1, wherein the artificial intelligence model is trained by training data sets for a normal battery cell, and learns a distribution pattern of the training data sets by using a distribution chart based on at least two types of derived variables among a plurality of derived variables.

4. The low-voltage battery cell sorting apparatus of claim 3, wherein the designated range is a boundary determined based on the distribution pattern, and the sorting unit is further configured to sort, as the low-voltage battery cell, a battery cell having a standardized derived variable data set out of the determined boundary.

5. The low-voltage battery cell sorting apparatus of claim 1, wherein the processing data sets comprises an open circuit voltage (OCV) measured according to a time sequence of an activation process for each of the battery cells.

6. An operating method of a low-voltage battery cell sorting apparatus, the operating method comprising:

   obtaining processing data sets of battery cells included in each of a plurality of battery trays;
   generating derived variable data sets comprising at least two types of derived variables for each of the battery cells, by using the processing data sets;
   standardizing the derived variable data sets; and
   sorting, as a low-voltage battery cell, a battery cell having a standardized derived variable data set out of a designated range among the standardized derived variable data sets, by using an artificial intelligence model.

7. The operating method of claim 6, wherein the standardizing comprises standardizing the derived variable data sets by using an average and a standard deviation based on a quartile of the derived variable data sets.

8. The operating method of claim 6, wherein the artificial intelligence model is trained by training data sets for a normal battery cell, and learns a distribution pattern of the training data sets by using a distribution chart based on at least two types of derived variables among a plurality of derived variables.

9. The operating method of claim 8, wherein the designated range is a boundary determined based on the distribution pattern, and the sorting comprises sorting, as the low-voltage battery cell, a battery cell having a standardized derived variable data set out of the determined boundary.

10. The operating method of claim 6, wherein the processing data sets comprises an open circuit voltage (OCV) measured according to a time sequence of an activation process for each of the battery cells.

FIG.1

LOW-VOLTAGE BATTERY
CELL SORTING
APPARATUS
20

| FIRST TRAY | COMMUNICATION CIRCUIT | DATA OBTAINING UNIT |
|---|---|---|
| 221 | 200 | 242 |

| SECOND TRAY | SENSOR | DATA PRE-PROCESSING UNIT |
|---|---|---|
| 223 | 220 | 244 |

| THIRD TRAY | MEMORY | SORTING UNIT |
|---|---|---|
| 225 | 240 | 246 |

| | PROCESSOR | MODEL TRAINING UNIT |
|---|---|---|
| | 260 | 248 |

23

USER TERMINAL
24

FIG.2

FIG.3

FIG.4

OBTAIN PROCESSING DATA SETS —500

PRE-PROCESS PROCESSING DATA SETS —502

SORT LOW-VOLTAGE BATTERY CELL BY
USING PRE-TRAINED ARTIFICIAL
INTELLIGENCE MODEL —504

FIG.5

# EP 4 644 929 A1

## INTERNATIONAL SEARCH REPORT

| | International application No. |
|---|---|
| | **PCT/KR2024/002871** |

**A. CLASSIFICATION OF SUBJECT MATTER**

**G01R 31/385**(2019.01)i; **G01R 31/396**(2019.01)i; **G01R 31/367**(2019.01)i; **G01R 19/00**(2006.01)i; **G01R 19/165**(2006.01)i

According to International Patent Classification (IPC) or to both national classification and IPC

**B. FIELDS SEARCHED**

Minimum documentation searched (classification system followed by classification symbols)

G01R 31/385(2019.01); G01R 31/36(2006.01); G01R 31/367(2019.01); G06F 16/21(2019.01); G06F 16/215(2019.01); G06F 16/31(2019.01); G06F 16/35(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 트레이(tray), 데이터(data), 파생 변수(derived variable), 표준화(normalization), 저전압(low voltage)

**C. DOCUMENTS CONSIDERED TO BE RELEVANT**

| Category* | Citation of document, with indication, where appropriate, of the relevant passages | Relevant to claim No. |
|---|---|---|
| A | KR 10-2020-0117594 A (LG CHEM, LTD.) 14 October 2020 (2020-10-14)<br>See paragraphs [0014]-[0017] and figures 1-2. | 1-10 |
| A | KR 10-2021-0086175 A (POSCO ICT COMPANY LTD.) 08 July 2021 (2021-07-08)<br>See claims 1-11 and figure 2. | 1-10 |
| A | KR 10-2022-0169433 A (LG CHEM, LTD.) 27 December 2022 (2022-12-27)<br>See paragraphs [0072]-[0073] and figure 3. | 1-10 |
| A | KR 10-2020-0039215 A (LG CHEM, LTD.) 16 April 2020 (2020-04-16)<br>See paragraphs [0057]-[0067] and figure 4. | 1-10 |
| A | KR 10-2110350 B1 (WISEITECH CO., LTD.) 08 June 2020 (2020-06-08)<br>See paragraphs [0036]-[0042] and figure 1. | 1-10 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **07 June 2024** | **10 June 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
| --- |
| **PCT/KR2024/002871** |

| Patent document cited in search report | | | Publication date (day/month/year) | Patent family member(s) | | | Publication date (day/month/year) |
| --- | --- | --- | --- | --- | --- | --- | --- |
| KR | 10-2020-0117594 | A | 14 October 2020 | None | | | |
| KR | 10-2021-0086175 | A | 08 July 2021 | KR | 10-2469610 | B1 | 21 November 2022 |
| KR | 10-2022-0169433 | A | 27 December 2022 | EP | 4300109 | A1 | 03 January 2024 |
| | | | | JP | 2024-509525 | A | 04 March 2024 |
| | | | | WO | 2022-265458 | A1 | 22 December 2022 |
| | | | | WO | 2022-265458 | A8 | 16 November 2023 |
| KR | 10-2020-0039215 | A | 16 April 2020 | CN | 112888954 | A | 01 June 2021 |
| | | | | EP | 3859363 | A1 | 04 August 2021 |
| | | | | KR | 10-2391533 | B1 | 28 April 2022 |
| | | | | US | 11940501 | B2 | 26 March 2024 |
| | | | | US | 2022-0043068 | A1 | 10 February 2022 |
| | | | | WO | 2020-071848 | A1 | 09 April 2020 |
| KR | 10-2110350 | B1 | 08 June 2020 | None | | | |

Form PCT/ISA/210 (patent family annex) (July 2022)

**EP 4 644 929 A1**